# EUROPEAN PATENT APPLICATION

(11) **EP 2 003 684 A1**
(43) Date of publication of application: **17.12.2008**
(21) Application number: 07739410.4
(22) Date of filing: 23.03.2007
(51) Int. Cl.: H01L 21/027

(54) **EXPOSURE APPARATUS, EXPOSURE METHOD AND DEVICE MANUFACTURING METHOD**

(30) Priority: 23.03.2006 JP 2006080343
(71) Applicant: Nikon Corporation, Tokyo 100-8331 (JP)
(72) Inventor: NAGASAKA, Hiroyuki, Tokyo 100-8331 (JP)
(74) Representative: Hooiveld, Arjen Jan Winfried
(86) International application number: PCT/JP2007/055969
(87) International publication number: WO 2007/119501

(57) **Abstract**

An exposure apparatus (EX) includes an optical system (PL) that irradiates a first exposure light (EL1) with a first wavelength onto a first exposure field (AR1) and irradiates a second exposure light (EL2) with a second wavelength different from the first wavelength onto a second exposure field (AR2), a predetermined field (S) on the substrate (P) being multiply exposed with an image of a first pattern (PA1) formed by the irradiation of the first exposure light (EL1) onto the first exposure field (AR1) and with an image of a second pattern (PA2) formed by the irradiation of the second exposure light (EL2) onto the second exposure field (AR2).

## Description

### TECHNICAL FIELD

The present invention relates to an exposure apparatus and exposure method for exposing a substrate, and to a device manufacturing method.

Priority is claimed on Japanese Patent Application No. 2006-080343, filed March 23, 2006, the contents of which are incorporated herein by reference.

### BACKGROUND ART

In an exposure apparatus used in a photolithography process, there is known an exposure apparatus, as disclosed in the following patent document, which multiply exposes a substrate.
[Patent Document 1]
   Japanese Unexamined Patent Application, First Publication No. H10-214783

### DISCLOSURE OF INVENTION

### PROBLEMS TO BE SOLVED BY THE INVENTION

In multiple exposure, there is the case where capability of efficiently forming a pattern with a variety of dimensions (line widths) is desired in addition to capability of forming a fine pattern on a substrate. That is to say, in multiple exposure, there is the case where capability of conforming to diversification of pattern dimensions (line widths) as well as formation of a fine pattern is desired. In this case, a plurality of masks are prepared, and exposure is executed for each of the masks; or a plurality of illumination conditions are prepared, and exposure is executed for each of the illumination conditions. To do this, time is needed for changing the masks, and for changing the illumination conditions and the like. Therefore, there is the possibility of a drop in the operation rate of the exposure apparatus and a drop in throughput.

A purpose of the present invention is to provide an exposure apparatus and exposure method that can suppress a drop in throughput, conform to formation of a fine pattern and diversification of pattern dimensions, and multiply expose a substrate with good efficiency, and to provide a device manufacturing method.

### MEANS FOR SOLVING THE PROBLEM

The present invention adopts the following configurations that correspond to the drawings, which describe the embodiments. However, any parenthesized symbol appended to an element is merely for the purpose of illustration and that element is not limited thereby.

According to a first aspect of the present invention, there is provided an exposure apparatus (EX) that exposes a substrate with an image of a pattern, including an optical system (PL) that irradiates a first exposure light (EL1) with a first wavelength onto a first exposure field (AR1) and irradiates a second exposure light (EL2) with a second wavelength different from the first wavelength onto a second exposure field (AR2), a predetermined field (S) on the substrate (P) being multiply exposed with an image of a first pattern (PA1) formed by the irradiation of the first exposure light (EL1) onto the first exposure field (AR1) and with an image of a second pattern (PA2) formed by the irradiation of the second exposure light (EL2) onto the second exposure field (AR2).

According to the first aspect of the present invention, it is possible to suppress a drop in throughput, conform to the formation of a fine pattern and diversification of pattern dimensions, and multiply expose a substrate with good efficiency.

According to a second aspect of the present invention, there is provided an exposure apparatus (EX) that exposes a substrate with an image of a pattern, including a third optical unit (33) that includes one optical element (FL) for guiding a first exposure light (EL1) with a first wavelength emitted from a first optical unit (31) to a first exposure field (AR1) and for guiding a second exposure light (EL2) with a second wavelength different from the first wavelength emitted from a second optical unit (32) to a second exposure field (AR2).

According to the second aspect of the present invention, it is possible to suppress a drop in throughput, conform to the formation of a fine pattern and diversification of pattern dimensions, and multiply expose a substrate with good efficiency.

According to a third aspect of the present invention, there is provided a device manufacturing method that uses an exposure apparatus (EX) of the above-mentioned aspects.

According to the third aspect of the present invention, a device can be manufactured using an exposure apparatus that can multiply expose a substrate with good efficiency.

According to a fourth aspect of the present invention, there is provided an exposure method including: irradiating a first field of a photosensitive layer formed on a substrate (P) with a first exposure light (EL1) having a first wavelength from a first pattern (PA1); and irradiating a second field with a second exposure light (EL2) having a second wavelength different from the first wavelength, the second field including at least a part of the first field irradiated with the first exposure light (EL1).

According to the fourth aspect of the present invention, it is possible to suppress a drop in throughput, conform to the formation of a fine pattern and diversification of pattern dimensions, and multiply expose a substrate with good efficiency.

### EFFECTS OF THE INVENTION

According to the present invention, it is possible to suppress a drop in throughput, conform to the formation of a fine pattern and diversification of pattern dimensions, and multiply expose a substrate with good efficiency. Therefore, devices can be manufactured with good productivity.

### BRIEF DESCRIPTION OF THE DRAWINGS

FIG. 1 is a schematic block diagram showing an exposure apparatus according to a first embodiment.
FIG. 2 is a perspective view showing one example of a mask stage according to the first embodiment.
FIG. 3 is a schematic diagram showing a relationship between a fist and second mask and a first and second illumination field, according to the first embodiment.
FIG. 4 is a schematic diagram showing a relationship between a shot field on a substrate and a first and second exposure field, according to the first embodiment.
FIG. 5 is a diagram for explaining characteristics of a photosensitive material.
FIG. 6 is a diagram for explaining how a pattern is made fine by use of a first exposure light and a second exposure light.
FIG. 7 is a schematic block diagram showing an exposure apparatus according to a second embodiment.
FIG. 8 is a schematic diagram showing a relationship between a shot field on a substrate and a first and second exposure field, according to the second embodiment.
FIG. 9 is a flowchart showing one example of a manufacturing procedure of a micro device.

### DESCRIPTION OF THE REFERENCE SYMBOLS

1: first light source unit, 2: second light source unit, 7: control apparatus, 31: first optical system, 32: second optical system, 33: third optical system, 40: optical member, 41: first reflecting surface, 42: second reflecting surface, 60: mask stage, 80: substrate stage, AR1: first exposure field, AR2: second exposure field, BR1: first optical path, BR2: second optical path, EL1: first exposure light, EL2: second exposure light, EX: exposure apparatus, FL: final optical element, IL1: first illumination system, IL2: second illumination system, M1: first mask, M2: second mask, P: substrate, PA1: first pattern, PA2: second pattern, PL: projection optical system, S: shot field

### BEST MODE FOR CARRYING OUT THE INVENTION

Hereunder is a description of embodiments of the present invention with reference to the drawings. However the present invention is not limited to this description. In the following description, an XYZ rectangular co-ordinate system is established, and the positional relationship of respective members is described with reference to this XYZ rectangular co-ordinate system. A predetermined direction within a horizontal plane is made the X axis direction, a direction orthogonal to the X axis direction in the horizontal plane is made the Y axis direction, and a direction orthogonal to both the X axis direction and the Y axis direction (that is, a perpendicular direction) is made the Z axis direction. Furthermore, rotation (inclination) directions about the X axis, the Y axis and the Z axis, are respectively the θX, the θY, and the θZ directions.

### <First Embodiment>

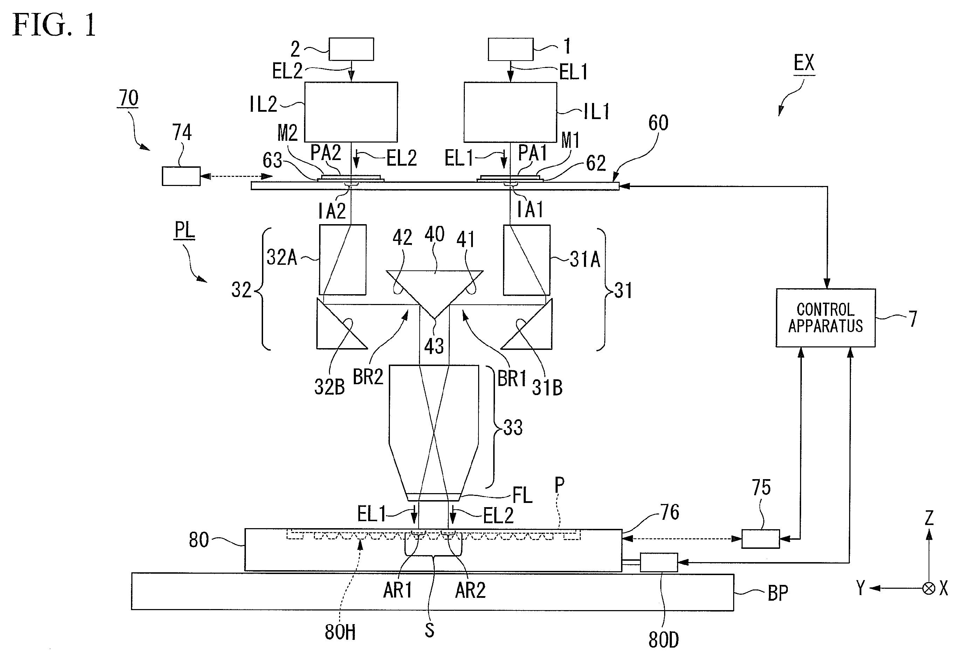

A first embodiment will be described. FIG. 1 is a schematic block diagram showing an exposure apparatus EX according to the first embodiment. In the present embodiment, the exposure apparatus EX includes a projection optical system PL that is capable of irradiating a first exposure light EL1 with a first wavelength onto a first exposure field AR1 and of irradiating a second exposure light EL2 with a second wavelength different from the first wavelength onto a second exposure field AR2. The exposure apparatus EX multiply exposes a shot field S with an image of a first pattern PA1 formed by the first exposure light EL1 irradiated onto the first exposure field AR1 and with an image of a second pattern PA2 formed by the second exposure light EL2 irradiated onto the second exposure field AR2.

In the present embodiment, the projection optical system PL sets the first exposure field AR1 and the second exposure field AR2 with a predetermined positional relationship at adjacent to a light emission side of the projection optical system PL, that is, an image plane side of the projection optical system PL. The projection optical system PL is capable of respectively irradiating the first exposure light EL1 and the second exposure light EL2 onto the first exposure field AR1 and the second exposure field AR2. In the present embodiment, the exposure apparatus EX is capable of forming an image of the first pattern PA1 on the first exposure field AR1 based on the first exposure light EL1 irradiated onto the first exposure field AR1 and is capable of forming an image of the second pattern PA2 on the second exposure field AR2 based on the second exposure light EL2 irradiated onto the second exposure field AR2. The exposure apparatus EX multiply exposes a shot field S on the substrate with the images of the first and second patterns PA1 and PA2 formed based on the first and second exposure lights EL1 and EL2 respectively irradiated onto the first and second exposure fields AR1 and AR2.

In FIG. 1, the exposure apparatus EX includes: a mask stage 60 that is capable of holding and moving a first mask M1 having the first pattern PA1 and a second mask M2 having the second pattern; a substrate stage 80 that is capable of holding and moving a substrate P; a measurement system 70 that is capable of measuring position information of the respective stages; a first illumination system IL1 that illuminates the first pattern PA1 of the first mask M1 with the first exposure light EL1; a second illumination system IL2 that illuminates the second pattern PA2 of the second mask M2 with the second exposure light EL2; a projection optical system PL; and a control apparatus 7 that controls the operation of the overall exposure apparatus EX. The projection optical system PL respectively forms (projects) the image of the first pattern PA1 illuminated with the first exposure light EL1 and the image of the second pattern PA2 illuminated with the second exposure light EL2 onto the first exposure field AR1 and the second exposure field AR2.

The substrate here includes one in which a photosensitive material (photoresist) is coated on a base material such as a semiconductor wafer or the like including a silicon wafer, and includes one in which film(s) of various types such as a protection film (top coat film) are coated in addition to a photosensitive film. The mask includes a reticule formed with a device pattern which is reduction size projected onto the substrate. It is, for example, one where a predetermined pattern is formed using a light shielding membrane such as chrome or the like on a transparent plate member such as a glass plate or the like. This transmission mask is not limited to a binary mask formed with a pattern by a light shielding film but includes for example a phase shift mask such as of a half tone type or a spatial frequency modulation type. In the present embodiment, a transmission mask is used as the mask. However, a reflecting mask can be used. Moreover, in the present embodiment, the first pattern PA1 is different from the second pattern PA2.

The exposure apparatus EX of the present embodiment is a scanning type exposure apparatus (a so-called scanning stepper) that projects the image of the first pattern PA1 of the first mask M1 and the image of the second pattern PA2 of the second mask M2 onto the substrate P, while the first mask M1 as well as the second mask M2, and the substrate P are synchronously moved in a predetermined scanning direction. In the present embodiment, the scanning direction (the synchronous movement direction) of the substrate P is the Y axis direction. The scanning direction (the synchronous movement direction) of the first mask M1 and the second mask M2 is also the Y axis direction. The exposure apparatus EX, while relatively moving the first exposure field AR1 as well as the second exposure field AR2 and the shot field S on the substrate P in the Y axis direction, respectively irradiates the first exposure light EL1 and the second exposure light EL2 onto the first exposure field AR1 and the second exposure field AR2 by means of the projection optical system PL. As a result, the shot field S on the substrate P is multiply exposed with the image of the first pattern PA1 and the image of the second pattern PA2 that are formed on the first exposure field AR1 and the second exposure field AR2. The substrate stage 80 is capable of moving the shot field S on the substrate P in the Y axis direction with respect to the first exposure field AR1 and the second exposure field AR2. The mask stage 60 is capable of moving the first mask M1 having the first pattern PA1 in the Y axis direction with respect to the first exposure light EL1, and is capable of moving the second mask M2 having the second pattern PA2 in the Y axis direction with respect to the second exposure light EL2. When multiply exposing the shot field S on the substrate P, the control apparatus 7 moves the shot field S on the substrate P in the Y axis direction by means of the substrate stage 80 in synchronous with the movement in the Y axis direction of the first mask M1 and the second mask M2 by the mask stage 60.

The first illumination system IL1 illuminates a first illumination field IA1 on the first mask M1 held in the mask stage 60, with the first exposure light EL1 of a uniform luminance distribution. The second illumination system IL2 illuminates a second illumination field IA2 on the second mask M2 held in the mask stage 60, with the second exposure light EL2 of a uniform luminance distribution.

The first illumination system IL1 illuminates the first pattern PA1 of the first mask M1 with the first exposure light EL1 with the first wavelength. The second illumination system IL2 illuminates the second pattern PA2 of the second mask M2 with the second exposure light EL2 with the second wavelength different from the first wavelength.

The exposure apparatus EX of the present embodiment has a first light source unit 1 corresponding to the first illumination system IL1, and a second light source unit 2 corresponding to the second illumination system IL2. That is to say, the exposure apparatus EX of the present embodiment has a plurality of light source units (laser emitting units). The first light source unit 1 emits the first exposure light (laser light) EL1 with the first wavelength. The second light source unit 2 emits the second exposure light (laser light) EL2 with the second wavelength different from the first wavelength.

In the present embodiment, the ArF excimer laser unit for an oscillation wavelength of 193 nm is used for the first light source unit 1. The KrF excimer laser unit for an oscillation wavelength of 268 nm is used for the second light source unit 2. In the present embodiment, the ArF excimer laser beam with a wavelength of 193 nm is used for the first exposure light EL1 emitted from the first illumination system IL1. The KrF excimer laser beam with a wavelength of 248 nm is used for the second exposure light EL2 emitted from the second illumination system IL2.

The first and second exposure lights EL1 and EL2 emitted from the first and second illumination systems IL1 and IL2 are not limited to KrF excimer laser beam (wavelength: 248 nm) and ArF excimer laser beam. For example, emission lines (g-line, h-line, i-line) emitted from a mercury lamp, F₂ laser beam (wavelength: 157nm), Kr₂ laser beam (wavelength: 146nm), Ar₂ laser beam (wavelength: 126nm), or the like can be used. Furthermore, the combination of light (wavelength) to be used as the first exposure light EL1 and light (wavelength) to be used as the second exposure light EL2 can be optionally set. That is, the types and combination of the first and second light source units to be used can be optionally selected.

Next is a description of the mask stage 60. The mask stage 60 is capable of moving the first mask M1 having the first pattern PA1 in the Y axis direction with respect to the first exposure light EL1 and is capable of moving the second mask M2 having the second pattern PA2 in the Y axis direction with respect to the second exposure light EL2. Position information of the mask stage 60 is measured by a measurement system 70.

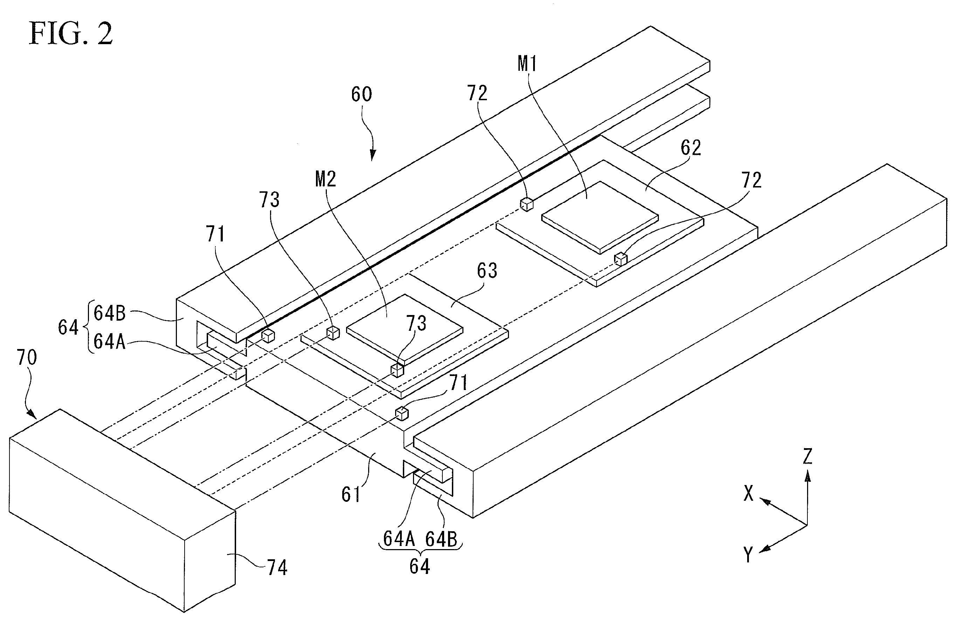

FIG. 2 is a perspective view showing the mask stage 60 and the measurement system 70 according to the present embodiment. The mask stage 60 includes: a main stage 61; a first substage 62 capable of moving on the main stage 61 while holding the first mask M1; and a second substage 63 capable of moving on the main stage 61 while holding the second mask M2.

The main stage 61 is for moving the first mask M1 and the second mask M2 in the Y axis direction. The main stage 61 holds the first mask M1 via the first substage 62 and holds the second mask M2 via the second substage 63. The main stage 61 is capable of holding and moving the first mask M1 and the second mask M2 in the same scanning direction (Y axis direction) via the first substage 62 and the second substage 63.

The main stage 61 has a comparatively long stroke length in the Y axis direction such that during scanning exposure of one shot field S on the substrate, the whole of the first pattern PA1 of the first mask M1 passes through the first illumination field IA1 and that the whole of the second pattern PA2 of the second mask M2 passes through the second illumination field IA2. The mask stage 60 includes a main stage driving unit 64 for moving the main stage 61 in the Y axis direction. The main stage driving unit 64 includes an actuator such as a linear motor. In the present embodiment, the main stage driving unit 64 includes movers 64A provided on both sides of the main stage 61 in the X axis direction and a stator 64B provided correspondingly to the movers 64A. The control apparatus 7 is capable of moving the main stage 61 in the Y axis direction by driving the main stage driving unit 64. By moving the main stage 61 in the Y axis direction, the first and second substages 62 and 63 on the main stage 61 also move together with the main stage 61. Consequently, by moving the main stage 61 in the Y axis direction, the first and second masks M1 and M2 held on the first and second substages 62 and 63 also move together with the main stage 61.

The first substage 62 is provided on the main stage 61 so as to be capable of moving in the X axis, the Y axis and the θZ directions with respect to the main stage 61. A first substage driving unit (not shown in the figure) having for example a voice coil motor is capable of finely moving the first mask M1 with respect to the main stage 61. Similarly, the second substage 63 is provided on the main stage 61 so as to be capable of moving in the X axis, the Y axis and the θZ directions with respect to the main stage 61. A second substage driving unit (not shown in the figure) having for example a voice coil motor is capable of finely moving the second mask M2 with respect to the main stage 61.

The measurement system 70 is capable of respectively measuring the position information of the main stage 61, the first substage 62 and the second substage 63. The measurement system 70 includes a laser interferometer 74 that projects measuring beams onto reflecting surfaces of reflecting members 71 provided on the main stage 61, of reflecting members 72 provided on the first substage 62, and of reflecting members 73 provided on the second substage 63 and receives the reflected beams and acquires position information of each of the main stage 61, the first substage 62, and the second substage 63. In the present embodiment, the laser interferometer 74 is disposed lateral to the +Y side of the mask stage 60. The reflecting member 71 includes for example a corner cube mirror. Two reflecting members 71 are provided on the main stage 61 at predetermined positions that can be irradiated with the measuring beams from the laser interferometer 74. Similarly, the reflecting member 72 includes for example a corner cube mirror. Two reflecting members 72 are provided on the first substage 62 at predetermined positions that can be irradiated with the measuring beams from the laser interferometer 74. Also similarly, the reflecting member 73 includes for example a corner cube mirror. Two reflecting members 73 are provided on the second substage 63 at predetermined positions that can be irradiated with the measuring beams from the laser interferometer 74. The measurement system 70 is capable of measuring the position information of the main stage 61, the first substage 62, and the second substage 63 in the Y axis direction and the θZ direction by use of the laser interferometer 74 and reflecting members 71, 72, and 73. While not shown in the figure, the measurement system 70 further includes reflecting members (reflecting surfaces) and a laser interferometer for measuring position information of the main stage 61, the first substage 62, and the second substage 63 in the X axis direction.

The measurement system 70 uses the laser interferometer 74 and the reflecting members 71 provided on the main stage 61 to measure the position information of the main stage 61 in the X axis, Y axis, and θZ directions. Moreover, the measurement system 70 uses the laser interferometer 74 and the reflecting members 72 and 73 provided on the first and second substages 62 and 63 to measure the position information of the first and second substages 62 and 63 in the X axis, Y axis, and θZ directions. The control apparatus 7 appropriately moves the main stage 61, the first substage 62, and the second substage 63, based on the measurement results of the measurement system 70, and performs position control of the first and second masks M1 and M2 held on the first and second substages 62 and 63. Furthermore, the control apparatus 7 moves at least one of the first substage 62 and the second substage 63 with respect to the main stage 61, and can thereby adjust the relative positional relationship between the first mask M1 and the second mask M2.

Next is a description of the projection optical system PL, with reference to FIG. 1. The projection optical system PL is for projecting an image of the first pattern PA1 of the first mask M1 which is illuminated by the first exposure light EL1, and an image of the second pattern PA2 of the second mask M2 which is illuminated by the second exposure light EL2, onto the substrate P at a predetermined projection magnification. In the projection optical system PL of the present embodiment, the projection magnification is for example a reduction system of for example 1/4, 1/5, or 1/8.

The projection optical system PL of the present embodiment has one final optical element FL positioned so as to face the surface of the substrate P. Through the one final optical element FL, the projection optical system PL respectively irradiates the first exposure light EL1 and the second exposure light EL2 onto the first exposure field AR1 and the second exposure field AR2. Here, the final optical element FL is an optical element nearest the image plane of the projection optical system PL among a plurality of optical elements.

The projection optical system PL of the present embodiment includes an optical member 40 that has a first reflecting surface 41 positioned in a first optical path BR1 as an optical path of the first exposure light EL1 from the first pattern PA1 and has a second reflecting surface 42 positioned in a second optical path BR2 as an optical path of the second exposure light EL2 from the second pattern PA2. In the present embodiment, the optical member 40 includes a prism. The first reflecting surface 41 and the second reflecting surface 42 are arranged at positions optically conjugate with the first exposure field AR1 and the second exposure field AR2 or in the vicinity thereof.

Furthermore, the projection optical system PL of the present embodiment has: a first optical system 31 that guides the first exposure light EL1 from the first pattern PA1 to the first reflecting surface 41; a second optical system 32 that guides the second exposure light EL2 from the second pattern PA2 to the second reflecting surface 42; and a third optical system 33 that includes the final optical element FL and respectively guides the first exposure light EL1 reflected by the first reflecting surface 41 and the second exposure light EL2 reflected by the second reflecting surface 42 to the first exposure field AR1 and the second exposure field AR2.

The first optical system 31 includes: an optical element group 31 A that includes a plurality of reflection optical elements (lenses) having predetermined refractive power; and a reflecting member that has a reflecting surface 31B for reflecting the first exposure light EL1 having passed through the optical element group 31A toward the first reflecting surface 41. The second optical system 32 similarly includes: an optical element group 32A that includes a plurality of reflection optical elements (lenses) having predetermined refractive power; and a reflecting member that has a reflecting surface 32B for reflecting the second exposure light EL2 having passed through the optical element group 32A toward the second reflecting surface 42. The third optical system 33 includes an optical element group that includes a plurality of reflection optical elements (lenses) with predetermined refractive power. In the present embodiment, each of the first, second, and third optical systems 31, 32, and 33 forms the image of the pattern one time. As a result, the optical system (reflection optical system) positioned between the first pattern PA1 and the first exposure field AR1 forms the image two times. The optical system (reflection optical system) positioned between the second pattern PA2 and the second exposure field AR2 also forms the image two times.

In the present embodiment, the first reflecting surface 41 and the second reflecting surface 42 are inclined with respect to the XY plane. The ridge line (vertex) 43 formed by the first reflecting surface 41 and the second reflecting surface 42 is parallel with the X axis. In the optical member 40, a convex portion is formed by the first reflecting surface 41 and the second reflecting surface 42 so as to protrude toward the third optical system 33 including the final optical element FL. The cross-section of the protruding portion of the optical member 40 taken along a plane parallel with the YZ plane is a V shape, which is formed by the first reflecting surface 41 and the second reflecting surface 42.

The first exposure light EL1, from the first pattern PA1, traveling along the first optical path BR1 passes through the first optical system 31 and is then reflected by the first reflecting surface 41 to be guided to the final optical element FL of the third optical system 33. The second exposure light EL2, from the second pattern PA2, traveling along the second optical path BR2 passes through the second optical system 32 and is then reflected by the second reflecting surface 42 to be guided to the final optical element FL of the third optical system 33. The first exposure light EL1 and the second exposure light EL2 guided to the final optical element FL are respectively irradiated onto the first exposure field AR1 and the second exposure field AR2 via the final optical element FL. In this manner, the projection optical system PL of the present embodiment is capable of irradiating the first exposure light EL1 from the first pattern PA1 onto the first exposure field AR1 via the final optical element FL, and is capable of irradiating the second exposure light EL2 from the second pattern PA2 onto the second exposure field AR2 via the final optical element FL.

Of the projection optical system PL, only the first exposure light EL1 is irradiated onto the first optical system 31; only the second exposure light EL2 is irradiated onto the second optical system 32; and both the first exposure light EL1 and the second exposure light EL2 are irradiated onto the third optical system 33. In the present embodiment, optical characteristics of the first, second, and third optical systems 31, 32, and 33 are optimized such that each of the image of the first pattern PA1 formed by the first exposure light EL1 and the image of the second pattern PA2 formed by the second exposure light EL2 is formed (projected) with desired imaging characteristics.

An imaging characteristic adjusting unit, as disclosed for example in Japanese Unexamined Patent Publication, First Publication Nos. S60-78454 and H11-195602, and in PCT International Patent Publication No. WO03/65428, can be provided which is capable of adjusting an imaging characteristic of the image by the projection optical system. The imaging characteristic adjusting unit includes an optical element driving mechanism that is capable of moving a part of a plurality of optical elements of the projection optical system PL. It is capable of adjusting the images of the first and second patterns PA1 and PA2 by the projection optical system PL by use of the optical element driving unit. The imaging characteristic adjusting unit can include a pressure adjusting mechanism that adjusts the pressure of a gas in space(s) between some optical elements held inside the lens barrel of the projection optical system PL.

Next is a description of the substrate stage 80. The substrate stage 80 is capable of holding and moving the substrate P within a predetermined field including the first exposure field AR1 and the second exposure field AR2 which are irradiated with the first exposure light EL1 and the second exposure light EL2. As shown in FIG. 1, the substrate stage 80 has a substrate holder 80H. The substrate stage 80 is moveable by drive of a substrate stage drive unit 80D including an actuator such as a linear motor, in directions of 6 degrees of freedom of the X axis, the Y axis, the Z axis, the θX, the θY, and the θZ directions, on the base member BP in a condition with the substrate P held on the substrate holder 80H.

The position information of the substrate stage 80 (and consequently the substrate P) is measured by a laser interferometer 75 of the measurement system 70. The laser interferometer 75 measures the position information related to the X axis, the Y axis, and the θZ directions of the substrate stage 80 using a reflecting surface 76 which is provided on the substrate stage 80. Furthermore, the surface information (position information related to the Z axis, the θX, and the θY directions) of the surface of the substrate P held on the substrate stage 80 is detected by a focus leveling system (not shown in the figure). The control apparatus 7 drives the substrate stage drive unit 80D based on the measurement result of the laser interferometer 75 and the detection result of the focus leveling detection system, and performs position control of the substrate P held in the substrate stage 80.

Furthermore, the focus leveling detection system is one which detects surface position information of the substrate by measuring position information for a plurality of measurement points for the Z axis direction of the substrate P, as disclosed for example in U.S. Patent No. 6,608,681. Regarding the plurality of measurement points, at least one part can be set within the exposure field, or all of them can be set on the outside of the exposure field. The laser interferometer can also be capable of measuring the position information of the substrate stage in the Z axis, the θX, and the θY directions. More detail of this is disclosed for example in Published Japanese translation No. 2001-510577 of PCT International Publication (corresponding PCT International Publication No. WO99/28790). In this case, it is not necessary to provide the focus leveling detection system so as to be able to measure the position information of the substrate in the Z axis direction during the exposure operation onto the substrate, and position control of the substrate in relation to the Z axis, the θX and the θY directions can be performed using the measurement results of the laser interferometer, at least during the exposure operation.

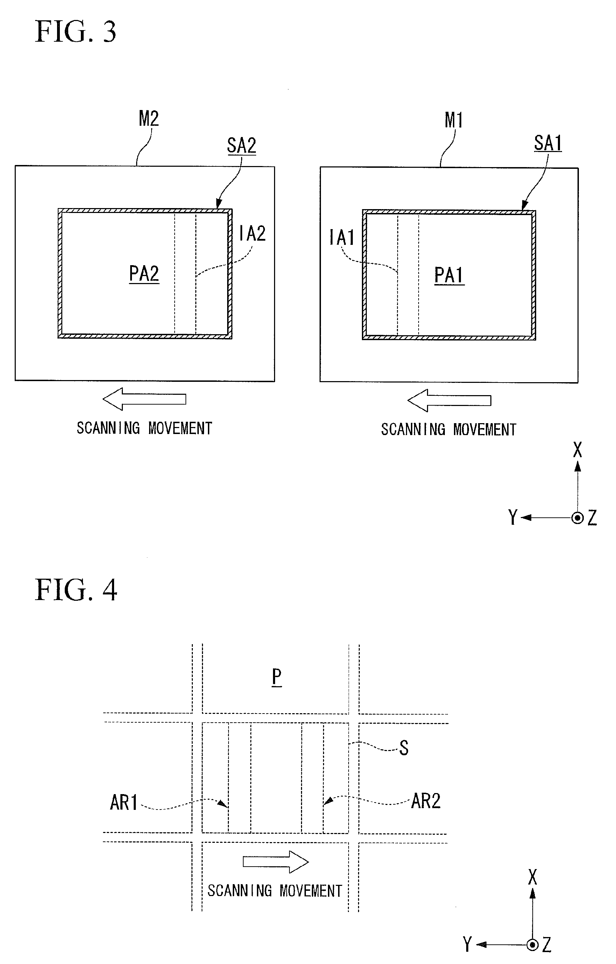

FIG. 3 is a schematic diagram showing a relationship between the first illumination field IA1 as well as the second illumination field IA2 and the fist mask M1 as well as the second mask M2. FIG. 4 is a schematic diagram showing a relationship between the first exposure field AR1 as well as the second exposure field AR2 and the shot field S as a field to be exposed on a substrate. In the present embodiment, the first exposure field AR1 onto which the first exposure light EL1 is irradiated and the second exposure field AR2 onto which the second exposure light EL2 is irradiated are projection fields of the projection optical system PL.

As shown in FIG. 3, in the present embodiment, the first mask M1 and the second mask M2 are aligned in the Y axis direction. The first illumination field IA1 for the first exposure light EL1 on the first mask M1 is set in a rectangular shape (slit shape) with the X axis direction as the longitudinal direction. The second illumination field IA2 for the second exposure light EL2 on the second mask M2 is also set in a rectangular shape (slit shape) with the X axis direction as the longitudinal direction.

As shown in FIG. 4, in the present embodiment, the first exposure field AR1 and the second exposure field AR2 are set in different positions in the Y axis direction. The substrate stage 80 is capable of moving the shot field S on the substrate P held thereon in the Y axis direction with respect to the first exposure field AR1 and the second exposure field AR2. Each of the first exposure field AR1 and the second exposure field AR2 is in a rectangular shape (slit shape) with the X axis direction as the longitudinal direction. The first exposure field AR1 and the second exposure field AR2 can be simultaneously positioned on a single shot field S. That is to say, in the present embodiment, the distance in the Y axis direction between the first exposure field AR1 (center of the first exposure field AR1) and the second exposure field AR2 (center of the second exposure field AR2) is smaller than the width in the Y axis direction of a single shot field S on the substrate P. Furthermore, in the present embodiment, the first exposure field AR1 and the second exposure field AR2 are separated in the Y axis direction.

The control apparatus 7, when exposing the substrate P, controls the mask stage 60 so that a first pattern forming field SA1 of the first mask M1 in which is formed at least the first pattern PA1 passes through the first illumination field IA1 for the first exposure light EL1 and that a second pattern forming field SA2 of the second mask M2 in which is formed at least the second pattern PA2 passes through the second illumination field IA2 for the second exposure light EL2, and moves the first mask M1 and the second mask M2 in the Y axis direction.

The control apparatus 7, when exposing the substrate P, controls the substrate stage 80 and moves the substrate P in the Y axis direction so that the shot field S on the substrate P passes through the first and second exposure fields AR1 and AR2 for the first and second exposure lights EL1 and EL2.

Next is a description of the method of exposing the substrate P using the exposure apparatus EX having the above configuration.

The first and the second masks M1 and M2 are respectively loaded on the first and second substages 62 and 63 of the mask stage 60. After the substrate P is loaded on the substrate stage 80, the control apparatus 7 performs predetermined process(es) such as adjustment of the positional relationship of the first pattern PA1 of the first mask M1, the second pattern PA2 of the second mask M2, and the shot field S on the substrate P. After completion of the predetermined process(es), the control apparatus 7 starts exposure onto the shot field S of the substrate P.

The first exposure light EL1 with the first wavelength emitted from the first illumination system IL1 illuminates the first pattern PA1 of the first mask M1 on the first substage 62. The second exposure light EL2 with the second wavelength emitted from the second illumination system IL2 illuminates the second pattern PA2 of the second mask M2 on the second substage 63.

The first exposure light EL1 from the first pattern PA1 of the first mask M1 is incident into the first reflecting surface 41 via the first optical system 31. The first exposure light EL1 reflected by the first reflecting surface 41 is guided to the final optical element FL of the third optical system 33 to be irradiated onto the first exposure field AR1. The image of the first pattern PA1 is formed on the first exposure field AR1, based on the first exposure light EL1 irradiated.

Similarly, the second exposure light EL2 from the second pattern PA2 of the second mask M2 is incident into the second reflecting surface 42 via the second optical system 32. The second exposure light EL2 reflected by the second reflecting surface 42 is guided to the final optical element FL of the third optical system 33 to be irradiated onto the second exposure field AR2. The image of the second pattern PA2 is formed on the second exposure field AR2, based on the second exposure light EL2 irradiated.

In synchronous with the movement in the individual scanning direction (Y axis direction) of the first and second masks M1 and M2 by the mask stage 60, the substrate stage 80 moves the shot field S on the substrate P in the scanning direction (Y axis direction) while at the same time the first and second exposure lights EL1 and EL2 respectively illuminate the first and second patterns PA1 and PA2 of the first and second masks M1 and M2. The first and second exposure fields AR1 and AR2 on the substrate P are respectively irradiated with the first and second exposure lights EL1 and EL2, and the shot field S on the substrate P is multiply exposed by the images of the first and second patterns PA1 and PA2.

In parallel with monitoring the position information of the first and second substages 62 and 63 of the mask stage 60 and the substrate stage 80 by the measurement system 70, the movement in the Y axis direction of the substrate P with respect to the first and second exposure fields AR1 and AR2, the movement in the Y axis direction of the first mask M1 with respect to the first illumination field IA1, and the movement in the Y axis direction of the second mask M2 with respect to the second illumination field IA2 are synchronously performed. Furthermore, the first and second exposure lights EL1 and EL2 are respectively irradiated onto the first and second exposure fields AR1 and AR2 to multiply expose the shot field S on the substrate P. In the present embodiment, during exposure of the shot field S on the substrate P and in the case where the substrate P is moved for example in the +Y direction, the first mask M1 and the second mask M2 are moved in the -Y direction.

In the present embodiment, in one round of the scanning operation, one shot field S on the substrate P can be multiply exposed by the image of the first pattern PA1 and the image of the second pattern PA2. The photosensitive material layer of the shot field S on the substrate P is multiply exposed by the first exposure light EL1 irradiated onto the first exposure field AR1 and the second exposure light EL2 irradiated onto the second exposure field AR2, without going through the development steps and the like.

Furthermore, on the substrate P, there are provided a plurality of shot fields S. By the control apparatus 7 repeating the scanning operation in the -Y direction of the substrate P and the scanning operation in the +Y direction, the plurality of shot fields S on the substrate P are sequentially multiply exposed.

As described above, in the present embodiment, the first exposure field AR1 and the second exposure field AR2 are respectively irradiated with the first exposure light EL1 and second exposure light EL2 that have mutually different wavelengths. By the image of the first pattern PA1 and image of the second pattern PA2 that are formed based on the irradiation, the shot field S on the substrate P can be multiply exposed with good efficiency. Furthermore, in the present embodiment, when the first exposure field AR1 and the second exposure field AR2 are respectively irradiated with the first exposure light EL1 and the second exposure light EL2, the substrate P is moved in the Y axis direction so that the shot field S on the substrate P passes through the first exposure field AR1 and the second exposure field AR2. As a result, the shot field S on the substrate P can be multiply exposed with good efficiency. In the present embodiment, in one round of the scanning operation, one shot field S can be multiply exposed by the image of the first pattern PA1 and the image of the second pattern PA2. This is advantageous for improvement in throughput. Moreover, by repetition of the scanning operation in the -Y direction of the substrate P and the scanning operation in the +Y direction, the plurality of shot fields S on the substrate P can be multiply exposed with good efficiency. Furthermore, since in one round of the scanning operation, one shot field S on the substrate P can be multiply exposed, both of the image of the first pattern PA1 and the image of the second pattern PA2 can be formed with a desired positional relationship in each of the shot fields S.

The resolution of the exposure apparatus changes according to the wavelength of exposure light. In the case where a fine pattern and a rough pattern are desired to be formed on the substrate P, for example, the fine pattern can be favorably formed on the substrate P using the first exposure light EL1 with the first wavelength and the rough pattern can be formed using the second exposure light EL2 with the second wavelength which is shorter than the first wavelength. In the present embodiment, in the case where a pattern with a variety of dimensions (line widths) are formed on the substrate P, exposure lights with wavelengths according to the respective pattern dimensions (line widths) can be used. Therefore, the present embodiment can conform to diversification of pattern dimensions (line widths). In the present embodiment, in one round of the scanning operation, the first pattern (fine pattern) PA1 and the second pattern (rough pattern) PA2 can be formed on the substrate P with good efficiency by use of the first exposure light EL1 with the first wavelength and the second exposure light EL2 with the second wavelength shorter than the first wavelength.

In the present embodiment, an ArF excimer laser unit is used as the first light source unit 1 for emitting the first exposure light EL1, and a KrF excimer laser unit is used as the second light source unit 2 for emitting the second exposure light EL2. However, as described above, the types and combination of the light source units to be used can be optionally selected. For example, an ArF excimer laser unit can be used as the first light source unit 1, and an inexpensive mercury lamp can be used as the second light source unit 2. In the case where the second pattern (rough pattern) PA2 can be formed on the substrate P with desired resolution by use of the light emitted from a mercury lamp, the cost for the units can be suppressed using an inexpensive mercury lamp as the second light source unit 2.

In the case where a photosensitive material having predetermined sensitivity characteristics respectively for the first exposure light EL1 with the first wavelength and the second exposure light EL2 with the second wavelength is used, the pattern formed on the substrate P can be made fine by adjusting the irradiation conditions of the first exposure light EL1 and the second exposure light EL2 onto the photosensitive material.

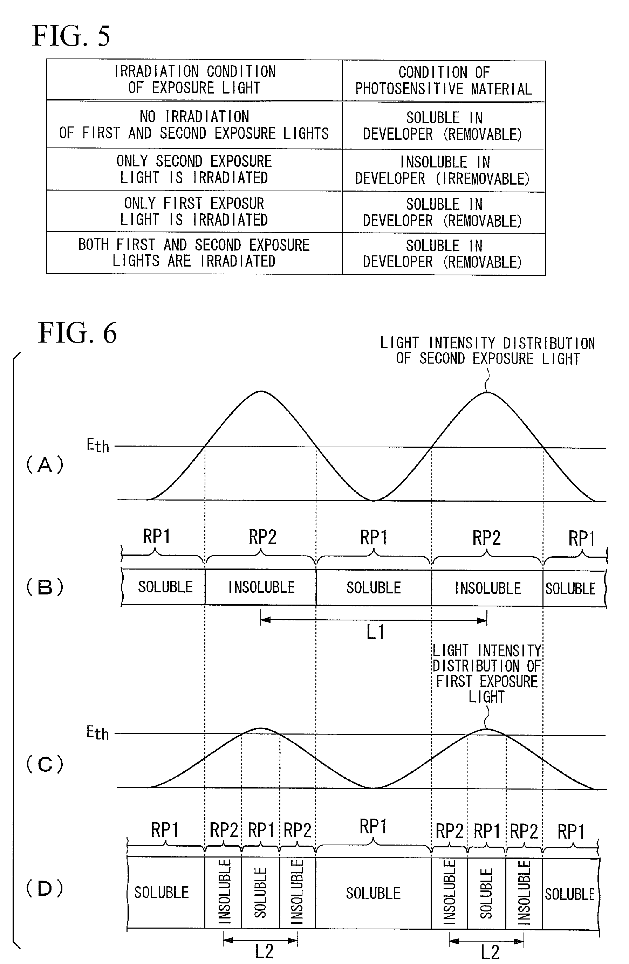

For example, the case will be considered where the substrate P spread with a photosensitive material having a characteristic shown in FIG. 5 is exposure processed and then the substrate P (photosensitive material) having been exposure processed is development processed. That is to say, the photosensitive material of the present embodiment has a characteristic of being removable (soluble in a developer) in the subsequent development process in the case where the first and second exposure lights are not irradiated or the first and second exposure lights having light intensity equal to or higher than a predetermined threshold Eth are not irradiated in the exposure process. The photosensitive material further has a characteristic of being irremovable (insoluble in the developer) in the subsequent development process in the case where only the second exposure light (KrF excimer laser beam) EL2 having light intensity equal to or higher than a predetermined threshold Eth is irradiated in the exposure process. The photosensitive material further has a characteristic of being removable (soluble in the developer) in the subsequent development process in the case where only the first exposure light (ArF excimer laser beam) EL1 having light intensity equal to or higher than a predetermined threshold Eth is irradiated in the exposure process. The photosensitive material further has a characteristic of being removable (soluble in the developer) in the subsequent development process in the case where both the first and second exposure lights EL1 and EL2 having light intensity equal to or higher than a predetermined threshold Eth is irradiated in the exposure process.

The photosensitive material of the present invention is a nonlinear resist that has a nonlinear reaction to the intensity of the irradiated light. In the case of being exposed by the second exposure light EL2 having a light intensity distribution shown in the portion (A) of FIG 6, the photosensitive material is formed with soluble fields RP1 that are soluble in the developer and insoluble fields RP2 that are insoluble in the developer, as shown in the portion (B) of FIG. 6.

In the case where such a photosensitive material is multiply exposed by the second exposure light EL2 having a light intensity distribution shown in the portion (A) of FIG. 6 and the first exposure light EL1 having a light intensity distribution shown in the portion (C) of FIG. 6, the photosensitive material is formed with soluble fields RP1 that are soluble in the developer and insoluble fields RP2 that are insoluble in the developer, as shown in the portion (D) of FIG. 6.

In the case where a device pattern is formed on the substrate P according to the insoluble fields RP2, the distance between the pattern lines has a first value L1 in the portion (B) of FIG. 6. In this case, through multiple exposure by the first exposure light EL1 with the first wavelength and the second exposure light EL2 with the second wavelength, the distance between the pattern lines can be made a second value L2 that is sufficiently smaller than the first value, as shown in the portion (D) of FIG. 6. In this manner, by multiple exposure by the first exposure light EL1 with the first wavelength and the second exposure light EL2 with the second wavelength, a fine pattern can be formed on the substrate P.

That is, through additional exposure of the first exposure light EL1 onto a part of the field of the photosensitive material that has been irradiated with the second exposure light EL, a pattern finer than the pattern that is formed by irradiation of only the first exposure light EL1 or of only the second exposure light EL2 can be formed.

If the photosensitive material has a characteristic of being insoluble when either the first exposure light EL1 or the second exposure light EL2 is irradiated and of being soluble when both of the first exposure light EL1 and the second exposure light EL2 are irradiated, a fine pattern can be formed by irradiating the second exposure light EL2 and subsequently by irradiating the first exposure light EL1 onto a part of the field that has been irradiated with the second exposure light EL2, and at the same time a pattern can be also formed on the field that has not been irradiated with the second exposure light EL2 only by the first exposure light EL1.

An apparatus for multiply exposing the photosensitive material having the characteristic as shown in FIG. 5 by the first exposure EL1 and the second exposure light EL2 with a wavelength different from that of the first exposure light EL1 is not limited to the apparatus shown in FIG. 1 through FIG. 4.

That is to say, instead of exposing the photosensitive material by respectively irradiating the first exposure light EL1 and the second exposure light EL2 onto the first exposure field AR1 and the second exposure field AR2 via one final optical element, a layer of the photosensitive material on the substrate P can be exposed by the second exposure light EL2 which is irradiated onto the second exposure field AR2 via a second projection optical system and subsequently the layer of the photosensitive material on the substrate P, which has been exposed by the second exposure light EL2, can be multiply exposed by the first exposure light EL1 which is irradiated onto the first exposure field AR1 via a first projection optical system provided independently of the second projection optical system.

Alternatively, a substrate coated with the photosensitive material with the characteristic of FIG. 5 can be multiply exposed by an apparatus including the first and second projection optical systems as described above and further including: a first substrate stage that holds the substrate onto which the first exposure light EL1 is irradiated according to the first projection optical system; and a second substrate stage, provided separately from the first substrate stage, that holds the substrate onto which the second exposure light EL2 is irradiated according to the second projection optical system. In this case, the layer of the photosensitive material on the substrate is exposed by the second exposure light EL2 in a condition with the substrate being held on the second substrate stage. Subsequently, the substrate is moved from the second substrate stage to the first substrate stage to be held on the first substrate stage. Then, the layer of the photosensitive material on the substrate, which has been exposed by the second exposure light EL2, is multiply exposed by the first exposure light. The first projection optical system and the first substrate stage can be positioned in a chamber different from the chamber for the second projection optical system and the second substrate stage.

### <Second Embodiment>

Next is a description of a second embodiment. In the following description, components the same as or similar to the abovementioned first embodiment are denoted by the same reference symbols, and their descriptions are simplified or omitted.

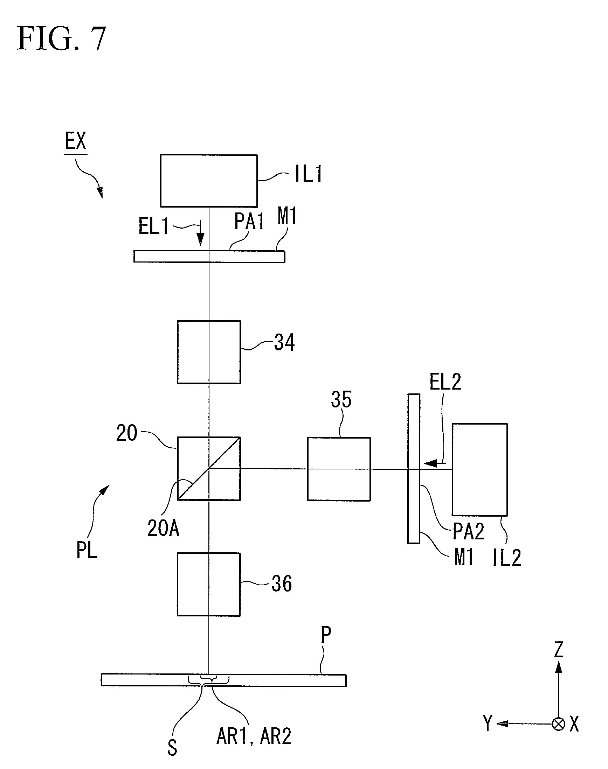

FIG. 7 is a schematic diagram showing an exposure apparatus EX according to the second embodiment. Also in the present embodiment, the exposure apparatus EX includes: a first illumination system IL1 that illuminates a first pattern PA1 of a first mask M1 with a first exposure light EL1 with a first wavelength; a second illumination system IL2 that illuminates a second pattern PA2 of a second mask M2 with a second exposure light EL2 with a second wavelength different from the first wavelength; and a projection optical system PL that projects an image of the first pattern PA1 illuminated with the first exposure light EL1 and an image of the second pattern PA2 illuminated with the second exposure light EL2 onto a substrate P.

The projection optical system PL of the present invention has a synthesizing optical element 20 that synthesizes the first exposure light EL1 from the first pattern PA1 and the second exposure light EL2 from the second pattern PA2. The synthesizing optical element 20 includes a branching optical element such as a half mirror that branches the optical paths of the incident first and second exposure lights EL1 and EL2. The synthesizing optical element 20 can include a polarization beam splitter.

Furthermore, the projection optical system PL of the present invention includes: a fourth optical system 34 that guides the first exposure light EL1 from the first pattern PA1 to the synthesizing optical element 20; a fifth optical system 35 that guides the second exposure light EL2 from the second pattern PA2 to the synthesizing optical element 20; and a sixth optical system 36 that respectively guides the first exposure light EL1 and second exposure light EL2 from the synthesizing optical element 20 to a first exposure field AR1 and a second exposure field AR2. The sixth optical system 36 includes one final optical element that faces a surface of a substrate P. The first exposure light EL1 and the second exposure light EL2 are respectively irradiated onto the first exposure field AR1 and the second exposure field AR2 via the one final optical element.

The first exposure light EL1 from the first pattern PA1 of the first mask M1 is incident into the synthesizing optical element 20 via the fourth optical system 34. A part of the first exposure light EL1 from the first pattern PA1 passes through a predetermined surface 20A of the synthesizing optical element 20 to be guided to the first exposure field AR1 by the sixth optical system 36. The second exposure light EL2 from the second pattern PA2 of the second mask M2 is incident into the synthesizing optical element 20 via the fifth optical system 35. A part of the second exposure light EL2 from the second pattern PA2 is reflected by the predetermined surface 20A of the synthesizing optical element 20 to be guided to the second exposure field AR2 by the sixth optical system 36.

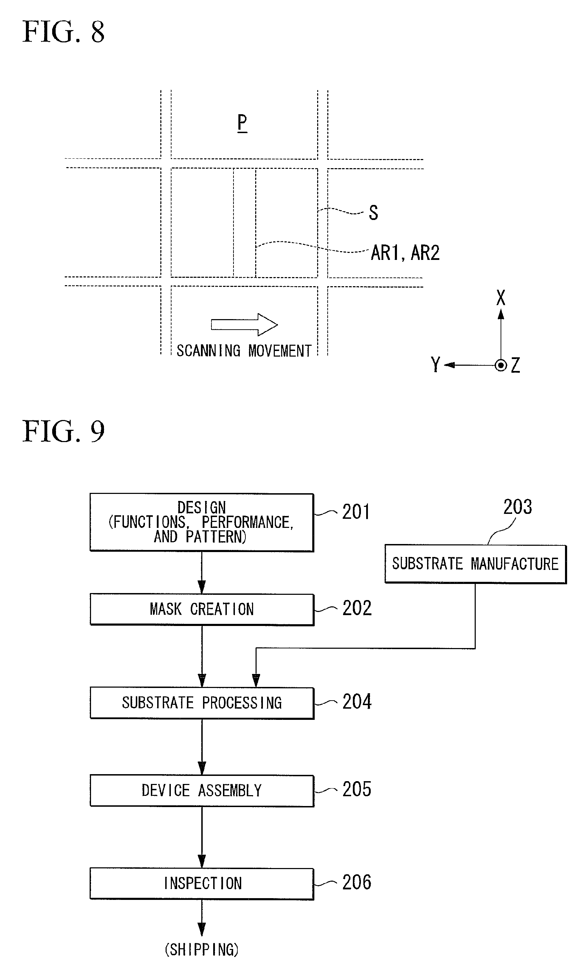

FIG 8 is a schematic diagram showing a relationship between the first exposure field AR1 as well as the second exposure field AR2 and the shot field S as a field to be exposed on the substrate P. In the present embodiment, the first exposure field AR1 and the second exposure field AR2 are overlapped.

The exposure apparatus EX of the present embodiment can also conform to formation of a fine pattern and diversification of pattern dimensions. Therefore, the shot field S on the substrate P can be multiply exposed with good efficiency.

In the first and second embodiments mentioned above, the first and second exposure lights EL1 and EL2 are respectively irradiated onto the first and second exposure fields AR1 and AR2 via the single final optical element that faces the surface of the substrate P. However, the first exposure light EL1 can be irradiated onto the first exposure field AR1 via a first final optical element that faces the surface of the substrate P and the second exposure light EL2 can be irradiated onto the second exposure field AR2 via a second final optical element, different from the first final optical element, that faces the surface of the substrate P.

In the above respective embodiments, the projection optical system PL is not limited to that described above, and for example either an equal magnification system or a magnification system can be used. Furthermore, the projection optical system PL can be a refractive system which does not include a reflection optical element, a reflection system which does not include a refractive optical element, or a cata-dioptric system which includes both a reflection optical system and a refractive optical system.

In each of the above embodiments, at least one of the size and shape of each the exposure field can be different from each other. For example, the width in the X axis direction and/or the width in the Y axis direction of the first exposure field AR1 and the second exposure field AR2 can be different.

In the above respective embodiments, respective irradiation of the first and second exposure lights EL1 and EL2 on each of the first exposure field AR1 and the second exposure field AR2 while the shot field S 1 is passing through the first exposure field AR1 and the second exposure field AR2 is continuous. However, in at least one of the exposure fields, the exposure light can be irradiated in a part of the period of time while the shot field S is passing. That is to say, only a part of the inside of the shot field S can be multiply exposed.

In the above respective embodiments, at least a part of one shot field S is multiply exposed by the first and second exposure lights EL1 and EL2 that have a different wavelength. However, the entirety of one shot field S can be exposed by only either one of the first and second exposure lights EL1 and EL2. That is to say, it is possible to perform exposure by switching between the first exposure light EL1 and the second exposure light EL2 for every shot, every substrate, or every lot.

As means for realizing such switching, operation of either one of the first light source unit and the second light source unit can be selectively stopped. Alternatively, light shielding plates can be positioned in the respective optical paths of the first exposure light EL1 and the second exposure light EL2, and the plates can be selectively actuated, thereby allowing only one of the first exposure light EL1 and the second exposure light EL2 to pass through the final optical element FL.

In the above respective embodiments, an immersion system such as disclosed for example in PCT International Patent Publication No. WO99/49504 can be applied. For example, a liquid immersion field can be formed on the substrate P so as to cover the first and second exposure fields AR1 and AR2, and the first and second exposure lights EL1 and EL2 can be irradiated onto the substrate P via the liquid. As the liquid, water (pure water) can be used. Other than water, for example a fluorocarbon fluid such as a perfluoropolyether (PFPE) or a fluorocarbon oil, or a cedar oil or the like can be used. Moreover as the liquid, a liquid with a refractive index that is higher than that of water with respect to the exposure light (for example a liquid with a refractive index of approximately 1.6 to 1.8) can be used. Furthermore, a final optical element FL can be formed from a material with a refractive index that is higher than that of quartz or fluorite (for example 1.6 or more). Here, as a liquid with a refractive index higher than that of pure water (for example, 1.5 or more), examples of the liquid include for example: a predetermined liquid with isopropanol with a refractive index of approximately 1.50, and glycerol (glycerine) with a refractive index of approximately 1.61, having a C-H bond and an O-H bond, a predetermined liquid (organic solvent) such as hexane, heptane, decane, and a predetermined liquid such as decalin (decahydronaphthalene) with a refractive index of approximately 1.60. Furthermore, the liquid can be a liquid where two or more types of optional liquids of these liquids are mixed, or a liquid where at least one of these liquids is added to (mixed with) pure water. Moreover, as the liquid, one in which an acid or a base such as H⁺, Cs⁺, and K⁺, or Cl⁻, SO₄²⁻, and PO₄²⁻ is added to (mixed with) pure water can be used, or a liquid in which fine particles of for example Al oxide are added to (mixed with) pure water can be used. The liquid is preferably one for which the light absorption coefficient is small, the temperature dependency is small, and which is stable with respect to the photosensitive material (or top coat film or anti-reflection film) painted on the surface of the projection optical system and/or the substrate. For the liquid, a supercritical liquid can be used. The substrate can be provided with a top coat film or the like for protecting the photosensitive material or the base material from the liquid. The final optical element can be formed from quartz (silica) or a monocrystalline material of a fluoride compound such as calcium fluoride (fluorite), barium fluoride, strontium fluoride, lithium fluoride, and sodium fluoride, or can be formed from a material with a refractive index that is higher than that of quartz or fluorite (for example 1.6 or more). As a material with a refractive index of 1.6 or more, for example, sapphire, germanium dioxide, or the like as disclosed in PCT International Patent Publication No. WO2005/059617 pamphlet or potassium chloride (refractive index: approximately 1.75) or the like as disclosed in PCT International Patent Publication No. WO2005/059618 pamphlet can be used.

In the case where the immersion method is used, not only the optical path on the image plane side of the final optical element but also the optical path on the object plane side of the final optical element can be filled with liquid, as disclosed for example in PCT International Patent Publication No. W02004/019128 (corresponding to U.S. Patent Publication No. 2005/0248856). Furthermore, a thin film with affinity to liquid or with a function of preventing dissolution can be formed on a part of the surface of the final optical element (including at least a contact surface with the liquid) or on the entirety thereof. Quartz has high affinity to liquid and thus a dissolution preventive film is not necessary therefor. However, as for fluorite, it is preferable that at least a dissolution preventive film be formed thereon.

The above respective embodiments are ones which measure the position information of the mask stage and the substrate stage using an interferometer system as the measurement system 70. However, the invention is not limited to these, and for example an encoder system that detects a scale (grating) provided for example on the top surface of the substrate stage can be used. In this case, it is preferable that a hybrid system provided with both the interferometer system and the encoder system be used to perform calibration on the detection results of the encoder system based on the measurement results of the interferometer system. Furthermore, the interferometer system and the encoder system can be alternately used, or both can be used, to perform position control of the substrate stage.

In the above respective embodiments, the shot field S on the substrate P is multiply exposed (double exposed) by the first exposure light EL1 with the first wavelength and the second exposure light EL2 with the second wavelength different from the first wavelength. However, a third exposure light with a third wavelength different from the first wavelength and the second wavelength can be additionally exposed onto the shot field S on the substrate P to multiply expose (triple expose) the shot field S. Obviously, four or more optional exposure lights with mutually different wavelengths can be used to multiply expose the shot field S on the substrate P.

It is to be noted that as for the substrate P of the above respective embodiments, not only a semiconductor wafer for manufacturing a semiconductor device, but also a glass substrate for a display device, a ceramic wafer for a thin film magnetic head, a master mask or reticle (synthetic quartz or silicon wafer) for use in an exposure apparatus, or a film member, etc. can be used. Furthermore, the shape of the substrate is not limited to a circle, and can be another shape such as a rectangle.

The exposure apparatus EX of the above respective embodiments can include a measurement stage that is capable of moving independently of the substrate stage for holding the substrate and that is mounted with a measurement member (for example, a reference member formed with a reference mark, and/or various types of photoelectronic sensors), as disclosed for example in Japanese Unexamined Patent Application, First Publication No. H11-135400, (corresponding to PCT International Patent Publication No. WO99/23692) and Japanese Unexamined Patent Application, First Publication No. 2000-164504, (corresponding to U.S. Patent No. 6,897,963).

In the above respective embodiments, a mask is used for forming a pattern. However, instead of this mask, an electronic mask (also called a variable form mask, an active mask or a pattern generator) for forming a variable pattern can be used. As an electronic mask, for example, a DMD (Deformable Micro-mirror Device or Digital Micro-mirror Device) as one type of non-radiative type image display element (also called a Spatial Light Modulator (SLM)) can be used. The DMD has a plurality of reflecting elements (fine mirrors) that are driven based on electronic data. The plurality of reflecting elements are arranged in a two-dimensional matrix shape on the surface of the DMD. They are driven for each of the elements to reflect and deflect the exposure light. Each of the reflecting elements is adjusted for the angle of its reflecting surface. The operation of the DMD can be controlled by the control apparatus. The control apparatus drives the reflecting elements of the DMD based on electronic data (pattern information) according to the pattern to be formed on the substrate, thereby patterning the exposure light irradiated by the illumination system by means of the reflecting elements. Using the DMD eliminates the need for replacing the masks and aligning the mask on the mask stage when the pattern is changed, which is required in the case of performing exposure by use of a mask (a reticle) on which a pattern is formed. In the exposure apparatus using an electronic mask, the substrate can be moved in the X axis direction and the Y axis direction by the substrate stage, without providing a mask stage. The exposure apparatus using a DMD is disclosed for example in Japanese Unexamined Patent Application, First Publication Nos. H08-313842 and 2004-304135, and U.S. Patent No. 6,778,257.

Furthermore, the present invention can also be applied to a multistage type exposure apparatus provided with a plurality of substrate stages as disclosed for example in Japanese Unexamined Patent Application, First Publication Nos. H10-163099, and H10-214783, and Published Japanese translation No. 2000-505958 of PCT International Publication.

The types of exposure apparatuses EX are not limited to exposure apparatuses for semiconductor element manufacture that expose a semiconductor element pattern onto a substrate P, but are also widely applicable to exposure apparatuses for the manufacture of liquid crystal display elements and for the manufacture of displays, and exposure apparatuses for the manufacture of thin film magnetic heads, image pickup elements (CCD), micro machines, MEMS, DNA chips, and reticles or masks.

As far as is permitted, the disclosures in all of the Japanese Patent Publications, U.S. Patents, and the like related to exposure apparatuses and the like cited in the above respective embodiments and modified examples, are incorporated herein by reference.

As described above, the exposure apparatus EX of the above embodiments is manufactured by assembling various subsystems including respective constituent elements, so that the prescribed mechanical precision, electrical precision and optical precision can be maintained. To ensure these respective precisions, performed before and after this assembly are adjustments for achieving optical precision with respect to the various optical systems, adjustments for achieving mechanical precision with respect to the various mechanical systems, and adjustments for achieving electrical precision with respect to the various electrical systems. The process of assembly from the various subsystems to the exposure apparatus includes mechanical connections, electrical circuit wiring connections, air pressure circuit piping connections, etc. among the various subsystems. Obviously, before the process of assembly from these various subsystems to the exposure apparatus, there are processes of individual assembly of each subsystem. When the process of assembly to the exposure apparatuses of the various subsystems has ended, the overall assembly is performed, and the various precisions are ensured for the exposure apparatus as a whole. Note that it is preferable that the manufacture of the exposure apparatus be performed in a clean room in which the temperature, the degree of cleanliness, etc. are controlled.

As shown in FIG. 9, microdevices such as semiconductor devices are manufactured by going through; a step 201 that performs microdevice function and performance design, a step 202 that creates the mask (reticle) based on this design step, a step 203 that manufactures the substrate that is the device base material, a step 204 including substrate processing steps such as a process that exposes the pattern on the mask onto a substrate by means of the exposure apparatus EX of the aforementioned embodiments, a process for developing the exposed substrate, and a process for heating (curing) and etching the developed substrate, a device assembly step (including treatment processes such as a dicing process, a bonding process and a packaging process) 205, and an inspection step 206, and so on.

## Claims

1. An exposure apparatus that exposes a substrate, comprising:
an optical system that irradiates a first exposure light having a first wavelength onto a first exposure field and irradiates a second exposure light having a second wavelength different from the first wavelength onto a second exposure field, a predetermined field on the substrate being multiply exposed with an image of a first pattern formed by the irradiation of the first exposure light onto the first exposure field and with an image of a second pattern formed by the irradiation of the second exposure light onto the second exposure field.

2. The exposure apparatus according to claim 1, wherein
the optical system comprises one optical element that faces a surface of the substrate, and
the first exposure light and the second exposure light are respectively irradiated onto the first exposure field and the second exposure field via the one optical element.

3. The exposure apparatus according to claim 2, wherein
the optical system comprises: a first reflecting surface positioned at a first optical path that is an optical path of the first exposure light from the first pattern; and a second reflecting surface positioned at a second optical path that is an optical path of the second exposure light from the second pattern, and
the first exposure light traveling along the first optical path is reflected by the first reflecting surface to be guided to the optical element, and the second exposure light traveling along the second optical path is reflected by the second reflecting surface to be guided to the optical element.

4. The exposure apparatus according to claim 3, wherein the first reflecting surface and the second reflecting surface are arranged at positions optically conjugate with the first exposure field and the second exposure field or in the vicinity thereof.

5. The exposure apparatus according to claim 3 or 4, wherein the optical system comprises: a first optical unit that guides the first exposure light from the first pattern to the first reflecting surface; a second optical unit that guides the second exposure light from the second pattern to the second reflecting surface; and a third optical unit, including the optical element, that respectively guides the first exposure light reflected by the first reflecting surface and the second exposure light reflected by the second reflecting surface to the first exposure field and the second exposure field.

6. The exposure apparatus according to any one of claims 1 to 5, wherein the predetermined field on the substrate is exposed while relative movement between the first exposure field as well as the second exposure field and the predetermined field on the substrate is executed in a predetermined scanning direction.

7. The exposure apparatus according to claim 6, wherein the first exposure field and the second exposure field are separated in the scanning direction.

8. The exposure apparatus according to any one of claims 1 to 7, further comprising:
a first moving unit that is capable of moving the first mask having the first pattern in a predetermined scanning direction with respect to the first exposure light and is capable of moving the second mask having the second pattern in a predetermined scanning direction with respect to the second exposure light; and
a second moving unit that is capable of moving the predetermined field on the substrate in a predetermined scanning direction with respect to the first exposure field and the second exposure field, wherein
the predetermined field on the substrate being multiply exposed, while the predetermined field on the substrate is moved in a scanning direction by the second moving unit, in synchronous with movements of the first mask and the second mask in the respective scanning directions thereof by the first moving unit.

9. An exposure apparatus that exposes a substrate, comprising:
a first optical unit that emits a first exposure light having a first wavelength;
a second optical unit that emits a second exposure light having a second wavelength; and
a third optical unit that includes one optical element, the one optical element guiding the first exposure light from the first optical unit to a first exposure field and guiding the second exposure light from the second optical unit to a second exposure field.

10. The exposure apparatus according to claim 9, wherein the one optical element faces a surface of the substrate.

11. The exposure apparatus according to claim 9 or 10, further comprising a selection unit that selectively guides only either one of the first exposure light and the second exposure light to the one optical element.

12. A device manufacturing method that uses the exposure apparatus according to any one of claims 1 to 11.

13. An exposure method, comprising:
irradiating a first field of a photosensitive layer formed on a substrate with a first exposure light having a first wavelength from a first pattern; and
irradiating a second field of the photosensitive layer with a second exposure light having a second wavelength different from the first wavelength, the second field including at least a part of the first exposure field irradiated with the first exposure light.

14. The exposure method according to claim 13, wherein a pattern formed on the photosensitive layer by irradiation of the first exposure light and the second exposure light is comparatively finer than a pattern formed on the photosensitive layer by irradiation only of the first exposure light or only of the second exposure light.

15. The exposure method according to claim 13, wherein an entirety of the second field irradiated with the second exposure light is included in a part of the first exposure field irradiated with the first exposure light.
